# EUROPEAN PATENT APPLICATION

(11) **EP 4 528 303 A1**
(43) Date of publication of application: **26.03.2025**
(21) Application number: 23199002.9
(22) Date of filing: 22.09.2023
(51) Int. Cl.: G01R 33/48, G01R 33/3815

(54) **DEVICE FOR USE WITH A COMBINED RADIOTHERAPY WITH MAGNETIC RESONANCE MONITORING**

(71) Applicant: Koninklijke Philips N.V., 5656 AG Eindhoven (NL)
(72) Inventor: FORTHMANN, Peter, Eindhoven (NL); VERNICKEL, Peter, Eindhoven (NL); LIPS, Oliver, 5656AG Eindhoven (NL)
(74) Representative: Philips Intellectual Property & Standards

(57) **Abstract**

According to the invention, a device for use with a combined radiotherapy with magnetic resonance monitoring, with a magnetic field-generating unit (1) for a magnetic resonance imaging apparatus (14), an actuator (19) for acting on the magnetic field-generating unit (1), and an operating control (18) for controlling the actuator (19), the magnetic field-generating unit (1) comprising a cryostat (2) with a bore (6) and a gradient coil (4) in the bore (6), the gradient coil (4) surrounding an examination area (7) in the bore (6) which is adapted for receiving a patient's body or a part of a patient's body, a conduction cooled static field magnet (10) arranged within the cryostat (2), wherein a straight through-channel (8) along a through-channel axis (13) is arranged in the cryostat (2), the static field magnet (10) and the gradient coil (4), such that the through-channel (8) connects the outside of the cryostat (2) with the bore (6) for applying a photon radiation field for the radiotherapy from the outside of the cryostat (2) through the through-channel (8) onto the patient's body or a part of a patient's body which is arranged in the bore (6), wherein the magnetic field-generating unit (1) is attached to the actuator (19). In this way, a magnetic field-generating unit for magnetic resonance imaging guided photon radiation therapy with improved signal-to-noise ratio is provided.

## Description

### FIELD OF THE INVENTION

The invention relates to the field of magnetic resonance imaging. In particular, the present invention relates to the field of a device for use with a combined radiotherapy with magnetic resonance monitoring.

### BACKGROUND OF THE INVENTION

The combination of magnetic resonance imaging and external beam radiation therapy in the form of a magnetic resonance imaging apparatus and a radiotherapy machine enables guided radiation therapy. This combination of a magnetic resonance imaging apparatus and a radiotherapy machine, a magnetic resonance linear accelerator (MR-Linac) facilitates magnetic resonance imaging immediately before and during application of an photon radiation field with high energy photons, without the need to position a patient in different devices and positioning inaccuracies resulting from this. The patient is placed on a treatment couch formed in a bore of the magnetic resonance imaging apparatus. Prior to the application of a photon radiation field with the radiotherapy machine, magnetic resonance images are acquired with the magnetic resonance imaging apparatus to check the positioning of the patient and, if necessary, to adjust the photon radiation field applied with the radiotherapy machine or adjust a position of the treatment couch.

For this purpose, the photon radiation field can be applied directly through a magnetic field-generating unit of the magnetic resonance imaging apparatus. However, since the high-energy photons of the photon radiation field are attenuated by material of the magnetic field-generating unit, the radiation therapy machine must generally provide photons of higher energy, respectively, cannot provide sufficient energy absorption in a tissue in a target volume in the patient without damaging tissue outside the target volume beyond a permissible exposure. In addition, the irradiation with high-energy photons causes secondary particles to emerge from the magnetic field-generating unit, which in turn also damage tissue of the patient outside the target volume.

Another approach is to arrange a circular recess in the magnetic field-generating unit so that the photon radiation field applied by the radiotherapy machine can enter the bore of the magnetic resonance imaging apparatus through this recess and thus be used for irradiation of the patient's tissue without prior attenuation in the magnetic field-generating unit.

From WO 2008/122899 A1 a magnet with primary and shield coil windings along an axial direction is known. The windings have an annular central gap which is axially extended about 10 cm and is spanned at an angle of 180°.

Further, US 6 198 957 discloses a radiotherapy machine and a magnetic resonance imaging system for imaging the region. The magnetic resonance imaging system has two spaced winding segments for producing a main DC magnetic field; the segments are located on opposite sides of the region.

While the latter approach employing a circular recess provides a good access for the photon radiation field, it becomes challenging and costly to homogenize the main magnetic field generated with the magnetic field-generating unit in the bore as well as limiting the magnetic flux density of the main magnetic field. The quality of the magnetic resonance images, determined by a signal-to-noise ratio, is thus decreased.

### SUMMARY OF THE INVENTION

It is an object of the invention to provide a magnetic field-generating unit for magnetic resonance imaging guided photon radiation therapy with improved signal-to-noise ratio.

According to the invention, this object is addressed by the subject matter of the independent claims. Preferred embodiments of the invention are described in the dependent claims.

Therefore, according to the invention, a device for use with a combined radiotherapy with magnetic resonance monitoring is provided, with a magnetic field-generating unit for a magnetic resonance imaging apparatus, an actuator for acting on the magnetic field-generating unit, and an operating control for controlling the actuator, the magnetic field-generating unit comprising a cryostat with a bore and a gradient coil in the bore, the gradient coil surrounding an examination area in the bore which is adapted for receiving a patient's body or a part of a patient's body, a conduction cooled static field magnet arranged within the cryostat, wherein a straight through-channel along a through-channel axis is arranged in the cryostat, the static field magnet and the gradient coil, such that the through-channel connects the outside of the cryostat with the bore for applying a photon radiation field for the radiotherapy from the outside of the cryostat through the through-channel onto the patient's body or a part of a patient's body which is arranged in the bore, wherein the magnetic field-generating unit is attached to the actuator, and the operating control is adapted for rotating the magnetic field-generating unit around a longitudinal axis of the bore employing the actuator.

This does not contradict the fact that further coils, such as a body coil, can be arranged in the magnetic field-generating unit. Depending on the expected scattering of the photons in the material of the other coil, the through-channel can then also be arranged in this or not.

Here, outside of the cryostat means the side of the cryostat opposite to the side of the cryostat facing the gradient coil. The through-channel is preferably circular in cross section along the through-channel axis and can be designed in such a way that different maximum field sizes of the photon radiation field can be applied into an examination area in the patient body. By the term "straight through-channel" it is meant that the through-channel is arranged along a straight axis. The through-channel is formed in the static field magnet and the gradient coil in such a way that no windings of the static field magnet and the gradient coil are interrupted.

The field size is the extent of the photon radiation field on the surface of the patient's body. The maximum field size can be specified by the order of magnitude of a width of a part of the patient's body, namely a torso of the patient for example. Preferably, the through-channel is large enough to allow the maximum field size of the photon radiation field, taking into account a distance from a coordinate origin formed in the examination area in the bore, an isocenter, to a target formed in a treatment head of a radiotherapy machine. The through-channel is thus designed in such a way that the desired photon radiation field can be applied through the through-channel into the bore and the photons are not scattered in the material of the cryostat and the gradient coil. With the exception of scattering of photons in the air in the through-channel, they pass through the through-channel essentially unhindered. Further, to be able to irradiate a target volume in the patient's body from different directions, the through-channel with the magnetic field-generating unit can be rotated by an angle with the actuator around the longitudinal axis of the bore. For this purpose, the actuator is attached, preferably force-locked, to the magnetic field-generating unit.

In addition, the application of the photon radiation field through the through-channel reduces the drop in the signal-to-noise ratio. The extension of the through-channel does not affect much the homogeneity of the main magnetic field generated by the static field magnet or the gradient field generated by the gradient coil. Corresponding corrections can be carried out efficiently.

The static field magnet is a conduction cooled magnet, also called a dry magnet, with essentially no gaseous or liquid coolant. This allows the magnetic field-generating unit to be rotated with the actuator controlled by the operating control. The movement of the magnetic field-generating unit that would cause gravity direction change dependent disturbances in the coolant are not present in the conduction cooled magnet. Preferably, the cryostat, the gradient coil and the bore are cylindrical, and both the cryostat and the gradient coil are coaxial with the longitudinal axis of the bore. The cryostat and the gradient coil thus form a cylindrical shell.

In general, it is possible to form the through-channel in the magnetic field-generating unit in different ways, so that the photon radiation field can be applied in the bore. According to a preferred embodiment of the invention, however, the through-channel axis is perpendicular to the longitudinal axis of the bore. If an origin of the coordinate system of the magnetic field-generating unit coincides with the isocenter, the target volume can be oriented so that the through-channel in the magnetic field-generating unit rotates around the isocenter, respectively the longitudinal axis.

In principle, the magnetic field-generating unit can be rotated in several ways. According to a preferred embodiment of the invention, however, the operating control is adapted to rotate the magnetic field-generating unit by an angle of up to 135°, preferably an angle of up to 180° around the longitudinal axis in clockwise and counterclockwise direction, respectively. This allows the through-channel to be positioned at any angle from -135° to +135°, respectively 0° to 360° around the longitudinal axis. At the same time, the rotation of the magnetic field-generating unit by +135° or -135° respectively +180° or -180° limits the complexity of cabling of the magnetic field-generating unit. In particular, the actuator in this context is preferably designed as a gantry drive. For this purpose, the magnetic field-generating unit is surrounded by a stationary construct that enables at least one stepper motor arranged on the magnetic field-generating unit to move along the construct and thus cause the rotation of the magnetic field-generating unit.

It is possible to design the operating control in different ways. According to a preferred embodiment of the invention, however, the operating control is adapted for driving the actuator synchronously to a gantry drive of a radiotherapy device. In the radiotherapy device, a gantry is a rotating frame comprising an electron gun, a linear accelerator and the treatment head. The gantry enables the treatment head to be positioned at various angles around the isocenter. The gantry drive here specifically rotates the gantry.

Basically, the through-channel can be formed in different ways. According to a preferred embodiment of the invention, however, the through-channel is conical and widens along the through-channel axis towards the bore. Thus, the through-channel is formed parallel to the edges of the photon radiation field in cross-section perpendicular to the longitudinal axis and by this there is no scattering of high energy photons in the magnetic field-generating unit.

It is possible to design the conduction cooled static field magnet in different ways. According to a preferred embodiment of the invention, however, the static field magnet is a high-temperature superconductor. The high temperature superconductor is preferably formed with a magnesium diboride magnet. A magnesium diboride magnet is defined as a magnet that comprises MgB₂ superconducting windings. Magnesium diboride (MgB₂) is a superconductor with a higher operating temperature than conventional NbTi conductors. MgB₂ becomes superconducting below 39 K; this is far less than the about 150 K of YBaCuO-HTC material, but still has the advantage that cooling capacity is much higher at 39 K than at 9.7 K, which is required for cooling NbTi. This relaxes many of the thermal constraints that drive the cost of a cryostat for magnetic resonance imaging.

The invention further concerns a magnetic resonance imaging apparatus comprising a device according to the above.

Further, according to the invention a system of a radiotherapy device for external field radiation therapy and a magnetic resonance imaging apparatus according to the above. In general, a radiotherapy machine for external field radiation therapy emits electrons from the electron gun and accelerates the emitted electrons in the linear accelerator. These accelerated electrons are directed to the target by a bending magnet and converted into high-energy photons by hitting the target. In addition, however, the radiotherapy machine can also be used for external beam radiation therapy with accelerated, i.e., high energy electrons. For this purpose, a vacuumized electron tube is used instead of the target, with which the high-energy electrons can be transported to the surface of the patient's body without scattering in air.

The system of the radiotherapy device for external field radiation therapy and the magnetic resonance imaging apparatus can be formed in different ways. According to a preferred embodiment of the invention, however, the system of the radiotherapy device for external field radiation therapy and the magnetic resonance imaging apparatus comprises a treatment head, wherein the treatment head is arranged coaxial to the through-channel axis outside the cryostat, and the treatment head is rotatable with the magnetic field-generating unit by the operating control such that the photon radiation field can be applied with the treatment head through the through-channel into the bore. The treatment head comprises the bending magnet, the target and a primary collimator. Coaxial to the through-channel axis means that the target in the treatment head, which represents the photon radiation field source, is aligned coaxially to the through-channel axis. It is particularly preferred here that the radiotherapy machine is integrally formed with the magnetic field-generating unit and is rotatable with the magnetic field-generating unit employing the actuator controlled by the operating control. This enables the immediate acquisition of magnetic resonance images before application of the photon radiation field.

According to a preferred embodiment of the invention, the system of the radiotherapy device for external field radiation therapy and the magnetic resonance imaging apparatus further comprises a treatment control unit connected to the radiotherapy machine and the operating control for transmitting signals, a magnetic resonance imaging sequencer connected to the magnetic resonance imaging apparatus for transmitting signals, wherein the treatment control unit is also connected to the magnetic resonance imaging sequencer for transmitting signals, wherein the magnetic resonance imaging sequencer is adapted for acquiring magnetic resonance images with the magnetic resonance imaging apparatus, the treatment control unit is adapted for controlling the magnetic resonance imaging sequencer, and the treatment control unit is further adapted for applying the photon radiation field as well as rotating the magnetic field-generating unit and the treatment head employing the operating control. This allows control of both magnetic resonance imaging and external field radiation therapy with the treatment control unit.

In a further preferred embodiment of the invention, the system of the radiotherapy device for external field radiation therapy and the magnetic resonance imaging apparatus moreover comprises a secondary collimator formed in the through-channel. In this context, the secondary collimator is particularly preferred a multileaf collimator and the treatment control unit is adapted for controlling the multileaf collimator. This reduces the distance of the secondary collimator to the target volume, which is beneficial for an energy drop of the photon radiation field at edges of the photon radiation field. A penumbra of the photon radiation field is reduced.

The invention further relates to a method of operating the system of the radiotherapy machine and the magnetic resonance imaging apparatus according to the above comprising the following steps: acquiring the magnetic resonance image, rotating the magnetic field-generating unit by an angle, applying the photon radiation field, and rotating the magnetic field-generating unit by a further angle. The fact that magnetic resonance imaging takes place immediately before the application of the photon radiation field means that more complex irradiation techniques such as gating can be performed. Monitoring the movement of the target volume by acquiring magnetic resonance images with the magnetic resonance imaging apparatus enables the possibility to apply the photon radiation beam only when the target volume is in a position intended for irradiation. Similarly, magnetic resonance imaging may be provided during the application of a photon radiation field. This allows, for example, the movement of the organs or the patient's movement in general to be monitored more precisely.

The invention further concerns a computer program for the system of the radiotherapy machine and the magnetic resonance imaging apparatus, comprising instructions which, when the program is executed by a computer, cause the computer to perform a method described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a magnetic field-generating unit according to a preferred embodiment of the invention,
Fig. 2 schematically depicts a cross sectional view of a system of a radiotherapy machine and a magnetic resonance imaging apparatus according to a preferred embodiment of the invention; and
Fig. 3 schematically depicts a scheme of a method according to a preferred embodiment of the invention.

### DETAILED DESCRIPTION OF EMBODIMENTS

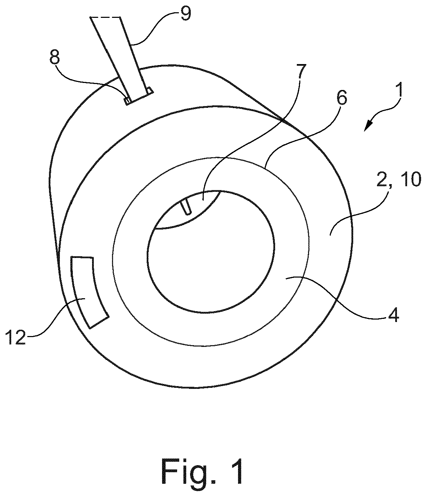

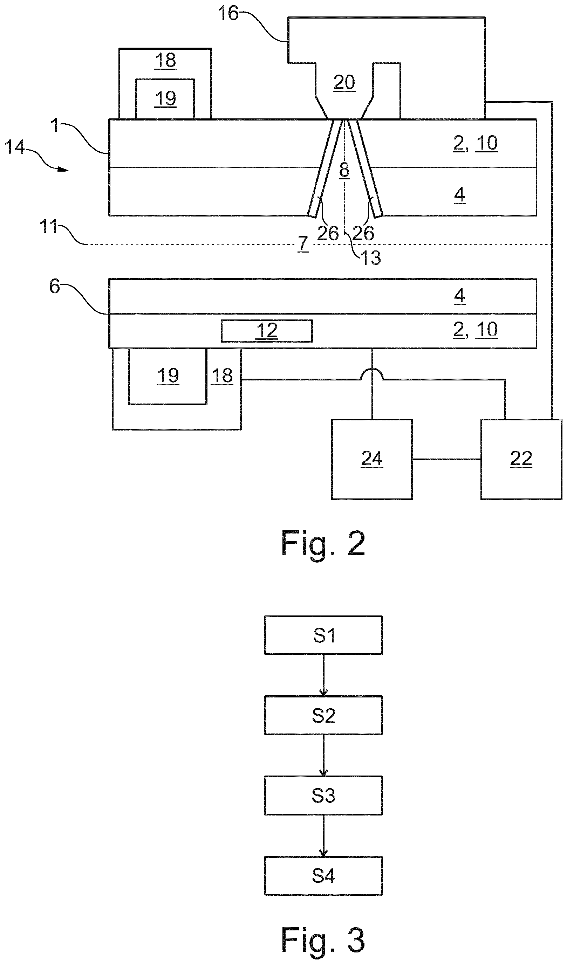

Fig. 1 schematically depicts a magnetic field-generating unit 1 according to a preferred embodiment of the invention. The magnetic field-generating unit 1 has a cylindrical cryostat 2 with a bore 6 and a gradient coil 4 in the bore 6. The bore 6 has an examination area 7 which is designed to receive the body of a patient or a part of the patient's body. The cryostat 2 is formed with a conduction cooled static field magnet 10 comprising a magnesium diboride superconductor embedded in a copper core, with which a main magnetic field is generated. In order to cool the static field magnet 10, 101 of liquid helium are arranged as coolant 12 in the cryostat 2. The magnetic field-generating unit 1 has a straight through-channel 8, which connects the outside of the cryostat 2 through the cryostat 2, the static field magnet 10 and the gradient coil 4 with the bore 6 and the examination area 7, so that a photon radiation field 9 can be applied to the examination area 7 with a radiotherapy machine 16 shown in Fig. 2.

The through-channel 8 has a through-channel axis 13 and is circular in cross-section. An actuator 19 acting on the magnetic field-generating unit 1 and an operating control 18 controlling the actuator 19 are shown in Fig. 2.

Fig. 2 schematically depicts a cross sectional view of a system of the radiotherapy machine 16 and a magnetic resonance imaging apparatus 14 according to a preferred embodiment of the invention. The magnetic resonance imaging apparatus 14 comprises the magnetic field-generating unit 1. The through-channel 8 widens conically towards the examination area 7 and a secondary collimator 26 is formed in the through-channel 8, which is used for passive field shaping of the photon radiation field 9. The radiotherapy machine 16 is integral with the magnetic resonance imaging apparatus 14 so that the actuator 19 with the operating control 18 can rotate both the magnetic field-generating unit 1 and the radiotherapy machine 16 around a longitudinal axis 11 of the bore 6. The actuator 19 is designed as a gantry drive with which the radiotherapy machine 16 and the magnetic field-generating unit 1 can be rotated 180° clockwise and counterclockwise so that the through-channel 8 can be positioned at an angle between 0° and 360° around the longitudinal axis 11.

A treatment head 20 of the radiotherapy machine 16 generating the photon radiation field 9 is arranged coaxially to the through-channel axis 13 outside the cryostat 2, whereby the through-channel axis 13 is again perpendicular to the longitudinal axis 11. The radiotherapy machine 16 and the operating control are connected to a treatment control unit 22 in such a way that the application of the photon radiation field 9 and the rotation with the operating control 19 can be controlled with the treatment unit 22. Furthermore, the treatment control unit 22 is connected to a magnetic resonance imaging sequencer 24, which in turn is connected to the magnetic resonance imaging apparatus 14, so that magnetic resonance images can be acquired with the magnetic resonance imaging sequencer 24 in response to an input of the treatment control unit 22.

Fig. 3 depicts a scheme of a method of operating the system of the radiotherapy machine 16 and the magnetic resonance imaging apparatus 14. Wherein in a first step the magnetic resonance image is acquired. In a second step, the magnetic field-generating unit 1 is rotated by an angle. The photon radiation field 9 is applied to the patient in a third step. In a fourth step, the magnetic field-generating unit 1 is rotated by a further angle.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| Magnetic field-generating unit | 1 |
| cryostat | 2 |
| gradient coil | 4 |
| bore | 6 |
| examination area | 7 |
| through-channel | 8 |
| photon radiation field | 9 |
| static field magnet | 10 |
| longitudinal axis | 11 |
| coolant | 12 |
| through-channel axis | 13 |
| magnetic resonance imaging apparatus | 14 |
| radiotherapy machine | 16 |
| operating control | 18 |
| actuator | 19 |
| treatment head | 20 |
| treatment control unit | 22 |
| magnetic resonance imaging sequencer | 24 |
| secondary collimator | 26 |

## Claims

1. Device for use with a combined radiotherapy with magnetic resonance monitoring, with a magnetic field-generating unit (1) for a magnetic resonance imaging apparatus (14), an actuator (19) for acting on the magnetic field-generating unit (1), and an operating control (18) for controlling the actuator (19),
the magnetic field-generating unit (1) comprising
a cryostat (2) with a bore (6) and a gradient coil (4) in the bore (6), the gradient coil (4) surrounding an examination area (7) in the bore (6) which is adapted for receiving a patient's body or a part of a patient's body,
a conduction cooled static field magnet (10) arranged within the cryostat (2), wherein
a straight through-channel (8) along a through-channel axis (13) is arranged in the cryostat (2), the static field magnet (10) and the gradient coil (4), such that the through-channel (8) connects the outside of the cryostat (2) with the bore (6) for applying a photon radiation field for the radiotherapy from the outside of the cryostat (2) through the through-channel (8) onto the patient's body or a part of a patient's body which is arranged in the bore (6), wherein
the magnetic field-generating unit (1) is attached to the actuator (19), and the operating control (18) is adapted for rotating the magnetic field-generating unit (1) around a longitudinal axis (11) of the bore employing the actuator (19).

2. Device according to claim 1, wherein the through-channel axis (13) is perpendicular to the longitudinal axis of the bore.

3. Device according to claim 2, wherein the operating control (18) is adapted to rotate the magnetic field-generating unit (1) by an angle of up to 135°, preferably an angle of up to 180° around the longitudinal axis (11) in clockwise and counterclockwise direction, respectively.

4. Device according to claim 2 or 3, wherein the operating control (18) is adapted for driving the actuator (19) synchronously to a gantry drive of a radiotherapy device (16).

5. Device according to any one of the preceding claims, wherein the through-channel (8) is conical and widens along the through-channel axis (13) towards the bore (6).

6. Device according to any one of the preceding claims, wherein the static field magnet (10) is a high-temperature superconductor.

7. Magnetic resonance imaging apparatus (14) comprising a device according to any one of claims 1 to 6.

8. System of a radiotherapy device (16) for external beam radiation therapy and a magnetic resonance imaging apparatus (14) according to claim 7.

9. System according to claim 8, with a treatment head (20), wherein the treatment head (20) is arranged coaxial to the through-channel axis (13) outside the cryostat (2), and
the treatment head (20) is rotatable with the magnetic field-generating unit (1) by the operating control (18) such that the photon radiation field can be applied with the treatment head (20) through the through-channel (8) into the bore (6).

10. System according to claim 9 comprising a treatment control unit (22) connected to the radiotherapy machine (16) and the operating control (18) for transmitting signals,
a magnetic resonance imaging sequencer (24) connected to the magnetic resonance imaging apparatus (14) for transmitting signals, wherein
the treatment control unit (22) is also connected to the magnetic resonance imaging sequencer (24) for transmitting signals, wherein
the magnetic resonance imaging sequencer (24) is adapted for acquiring magnetic resonance images with the magnetic resonance imaging apparatus (14),
the treatment control unit (22) is adapted for controlling the magnetic resonance imaging sequencer (24), and
the treatment control unit (22) is further adapted for applying the photon radiation field as well as rotating the magnetic field-generating unit (1) and the treatment head (20) employing the operating control (18).

11. System according to any one of the claims 8 to 10 with a secondary collimator (26) formed in the through-channel (8).

12. Method of operating the system of the radiotherapy machine (16) and the magnetic resonance imaging apparatus (14) according to any one of claims 8 to 11 comprising the following steps:
S1) acquiring the magnetic resonance image,
S2) rotating the magnetic field-generating unit (1) by an angle,
S3) applying the photon radiation field, and
S4) rotating the magnetic field-generating unit (1) by a further angle.

13. Computer program for the system of the radiotherapy machine (16) and the magnetic resonance imaging apparatus (14), comprising instructions which, when the program is executed by a computer, cause the computer to perform a method according to claim 12.
